# EUROPEAN PATENT SPECIFICATION

(11) **EP 2 933 822 B1**
(45) Date of publication and mention of the grant of the patent: **06.01.2021**
(21) Application number: 15158756.5
(22) Date of filing: 12.03.2015
(51) Int. Cl.: H01J 37/32, C23C 16/04, H01L 21/311, H01L 21/3213

(54) **Non-contact physical etching process**
KONTAKTLOSER PHYSIKALISCHER ÄTZPROZESS
PROCÉDÉ DE GRAVURE PHYSIQUE SANS CONTACT

(30) Priority: 17.04.2014 TW 103114094
(43) Date of publication of application: 21.10.2015
(73) Proprietor: Zavtrod Innovation Corporation, Hsinchu City (TW)
(72) Inventor: Yang, Cheng-Wei, Hsinchu City (TW); Sukhomlinov, Vladimir Sergeevich, Vsevolozhsk District, Leningrad Region (RU)
(74) Representative: Becker & Kurig Partnerschaft Patentanwälte PartmbB

(56) References cited:
- EP-A2- 0 443 154
- WO-A1-2009/006679
- US-A- 4 609 428
- US-A- 4 691 662
- US-A1- 2007 017 636

## Description

### BACKGROUND OF THE INVENTION

### 1. Field of the Invention

The present invention relates to the technology field of plasma etching, and more particularly to a non-contact physical etching process.

### 2. Description of the Prior Art

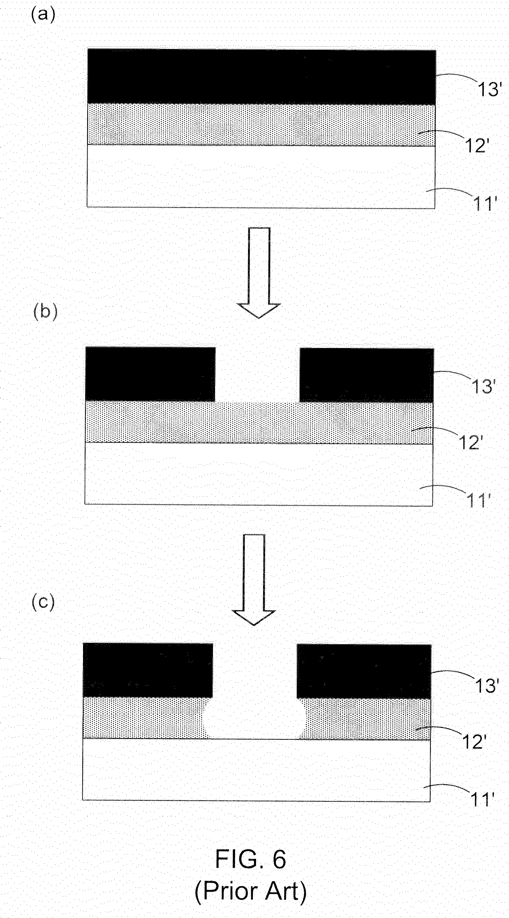

Etching process is one of the important manufacturing procedures for the planar fabrication of the chips with integrated circuits and some micro-electromechanical products. Etching technologies does well known be divided to dry etch and wet etch. Please refer to FIG. 6, there is shown a schematic diagram of a conventional wet etching process. In the diagram (a) of FIG. 6, a photoresist agent is coated onto a material layer 12' formed on a substrate 11' for forming a photoresist layer 13' on the material layer 12' in order to further process the material layer 12' to a define layer. Next, in the diagram (b) of FIG. 6, the formed photoresist layer 13' is subsequently treated with a lithography process, such that the portion of the material layer 12' that does not need to be etched is covered by photoresist layer 13'. Eventually, as the diagram (c) of FIG. 6 shows, the material layer 12' is therefore processed to the define layer having at least one specific pattern after a wet etching procedure is carried out.

It is well known that, the most important feature of the wet etch is the high selectivity performed by the used wet agent on the material under etching. However, the occurrence of undercut resulted from isotropic etching has become the primary drawback of the wet etch technology and the main cause for the wet etch technology unable to be applied in the etching procedure with the requirement of high narrow linewidth (<0.35µm).

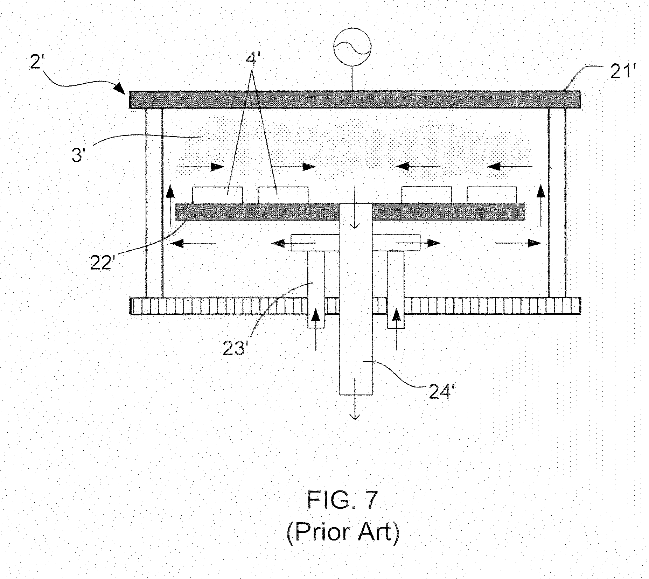

Differing from the wet etch, the dry etch is usually represented by plasma etch. Please refer to FIG. 7, which illustrates a schematic framework view of a conventional plasma etching apparatus. As shown in FIG. 7, the conventional plasma etching apparatus mainly consists of: a reaction chamber 2', an upper electrode plate 21', a lower electrode plate 22', at least one gas inputting pipe 23', and an exhaust pipe 24'. When operating the plasma etching apparatus to carry out a reactive ion etching process, an etch gas is inputted into the reaction chamber 2' via the gas inputting pipe 23', so as to be dissociated to charged ions by the plasma 3'. Furthermore, the ions of etch gas would be accelerated by applying a differential voltage between the upper electrode plate 21' and the lower electrode plate 21', and then the ions of etch gas would attack the target 4' disposed in the reaction chamber 2'. Moreover, when the target 4' is impacted by the accelerated ions, the etch gas would simultaneously chemically react with the target's surface. So that, from the above descriptions, it is able to understand that the physical and chemical etching technologies are both used in the conventional plasma etching apparatus for completing the reactive ion etching process.

On the other hand, reference document D1 (U.S. Patent No. 4,609,428A) discloses an apparatus for performing microwave plasma anisotropic dry etching. According to the technology of D1, a microwave power source creates a plasma from a gas with a relatively low pressure such as 10⁻³ to 10⁻⁴ Torr, such that the mean free path of the gas molecules exceeds the dimensions of the etching apparatus. A magnetic field is generated in a plasma generating chamber, a reaction chamber where in the substrate is mounted and a connecting chamber. The plasma discharge is enhanced by a cyclotron resonance magnetic field intensity corresponding to the frequency of the microwave power applied to the plasma chamber. The magnetic field creates a magnetic mirror which prevents the electrons in the plasma from entering into the reaction chamber so as to eliminate the generation of free radicals in which the reaction chamber which adversely affect the anisotropic etching ability.

Moreover, reference document D2 (U.S. Patent No. 4,691,662A) discloses a plasma apparatus which generates a radio frequency (UHF or microwave) disk plasma 16 and a hybrid plasma 45 derived from the disk plasma. The microwave plasma acts as a source of excited ion and free radical species and electrons for the second plasma which is hybrid in that it contains species from both microwave and dc (or rf depending on bias) excitation. The hybrid plasma can be used to treat an article 43 with different species than are present in the disk plasma and provides more control in this regard than a single plasma. Document WO-A1-2009/006679 discloses a method for transferring a pattern onto a target. The involved apparatus comprises a vacuum chamber divided into a first part and a second part; the first part and a second part have a connecting aperture; a means for producing a plasma of charged ions in the first part; a multi-perforated grid proximal to the aperture for limiting expansion of the ion sheath beyond the grid; an ion target; a means for biasing the ions toward the target for providing a controlled trajectory therebetween; and a pattern mask within the ion trajectory for transferring the pattern to the target.

Herein, it needs to further explain that at least one chemical solution is used for carrying out the isotropic etching of the wet etching process, and at least one chemical gas and plasma ions are applied in dry etching process for complete the anisotropic etching. Therefore, it is clearly that the chemical etching products are necessary to the conventional wet and dry etching processes; so that, the waste treatment of the chemical etching products has became an important issue. Moreover, because the chemical etching products are used in the conventional wet and dry etching processes, the said wet and dry etching technologies cannot be applied to carry out the etch process of biomaterials, medical substrates (for example, blood glucose test strip), and organic materials.

Besides, although some advanced etching technologies including electron beam etch, focused ion beam (FIB) etch and excimer laser etch have been entirely developed, the currently-used electron beam etching apparatus, FIB etching apparatus and excimer laser etching apparatus have an identical drawback of being unable to be applied to achieve mass production etching process. Moreover, another drawback of the laser etching apparatus is that its etching accuracy is limited to 10 µm. Opposite to the laser etching apparatus, the beam etching apparatus have another drawback of over expensive vacuum equipment.

Accordingly, in view of the conventional plasma etching apparatus, electron beam etching apparatus, FIB etching apparatus, and excimer laser etching apparatus still include shortcomings and drawbacks, the inventor of the present application has made great efforts to make inventive research thereon and eventually provided a non-contact physical etching process.

### SUMMARY OF THE INVENTION

The primary objective of the present invention is to provide a non-contact physical etching process as defined in claim 1. The step of providing the non-contact physical etching system of claim 1 can also be applied to complete the etch process of biomaterials, medical substrates (for example, blood glucose test strip), and organic materials.

### BRIEF DESCRIPTION OF THE DRAWINGS

The invention as well as a preferred mode of use and advantages thereof will be best understood by referring to the following detailed description of an illustrative embodiment in conjunction with the accompanying drawings, wherein:
FIG. 1A is a first framework view of a non-contact physical etching system, not forming part of the invention;
FIG. 1B is a is a second framework view of a non-contact physical etching system provided in the non-contact physical etching process according to the present invention;
FIG. 2 shows a framework diagram of a plasma generating device;
FIG. 3 illustrates schematic diagrams of a first mask and a second mask;
FIG. 4 shows an application diagram of the non-contact physical etching system;
FIG. 5 is a schematic framework view of an extensional embodiment for the non-contact physical etching system;
FIG. 6 shows a schematic diagram of a conventional wet etching process; and
FIG. 7 is a schematic framework view of a conventional plasma etching apparatus.

### DETAILED DESCRIPTION OF THE PREFERRED EMBODIMENTS

To more clearly describe a non-contact physical etching process according to the present invention, embodiments, including embodiments of the present invention, will be described in detail with reference to the attached drawings hereinafter.

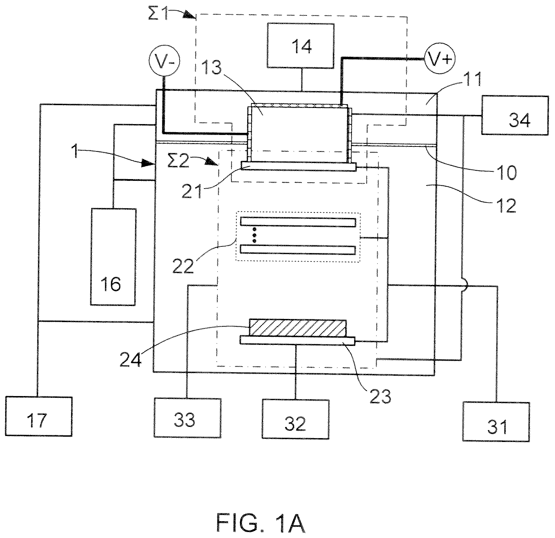

Please simultaneously refer to FIG. 1A, there is shown a first framework view for a non-contact physical etching system, which does not form part of the invention. As shown in FIG. 1A , the non-contact physical etching system mainly consists of: a main body 1, a hollow chamber 13 and a working gas supplying device 14. A partition member 10 is disposed in the main body 1 for separating the main body 1 into a first chamber 11 and a second chamber 12, wherein the first chamber 11 and the second chamber 12 are used as a plasma supplying chamber and a plasma etching chamber, respectively. Moreover, the hollow chamber 13 having an inlet opening and an outlet opening is deposed on the partition member 10 for simultaneously pass through the first chamber 11 and the second chamber 12. Besides, the working gas supplying device 14 is connected to the main body 1 for inputting a working gas into the hollow chamber 13 through the inlet opening.

As FIG. 1A shows, an anode plate is disposed on the inlet opening for connecting with an anode voltage V+; and oppositely, the hollow chamber 13 is connected with a cathode voltage V-. From above descriptions, it is able to understand that the said hollow chamber 13 is taken as a hollow cathode tube in this non-contact physical etching system. Thus, when the applied anode voltage V+ is greater than the applied cathode voltage V-, the hollow cathode discharge is produced in the hollow chamber 13, such that the working gas inputted into the hollow chamber 13 would be transformed into plasma by the hollow cathode discharge. Therefore, the plasma would further flow into the second chamber 12 (i.e., plasma etching chamber) through the outlet opening of the hollow chamber 13.

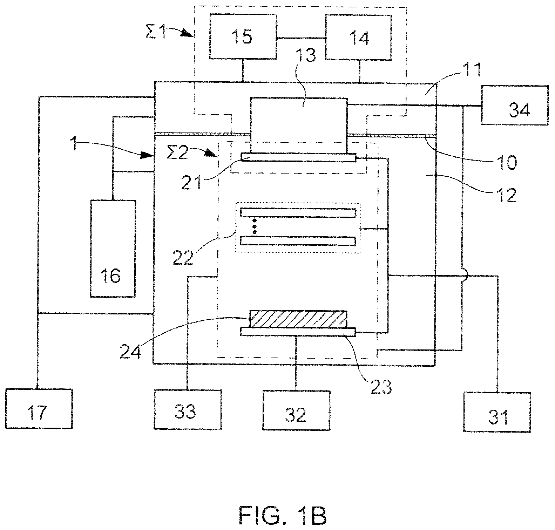

Continuously, please refer to FIG. 1B, where a second framework for the non-contact physical etching system provided in the non-contact physical etching process according to the invention is illustrated. In the second framework of the non-contact physical etching system, a plasma generating device 15 is connected to the main body 1 and the working gas supplying device 14, such that the working gas supplying device 14 is able to supply the working gas to the plasma generating device 15, and then the plasma generating device 15 would transform the working gas to the plasma. Therefore, the plasma would be inputted into the hollow chamber 13 by the plasma generating device 15.

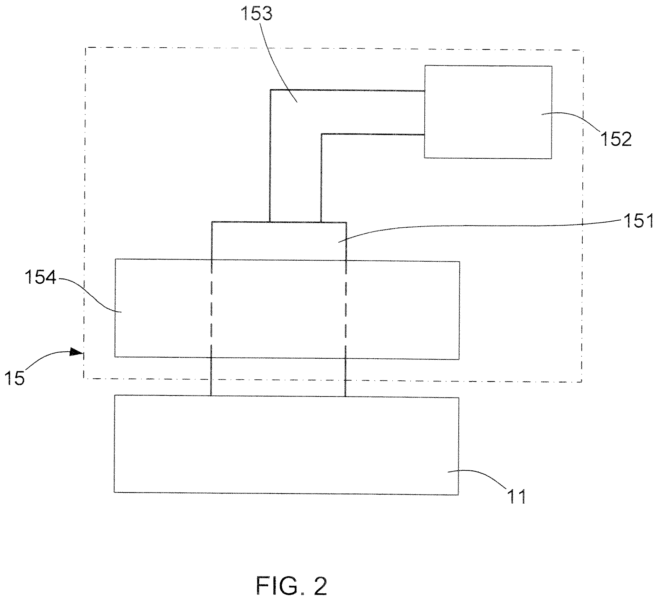

Please simultaneously refer to FIG. 2, there is shown a framework diagram of the plasma generating device 15. As shown in FIG. 2, the plasma generating device 15 is constituted by a reaction chamber 151, a microwave generator 152 and a magnetic module 154, wherein the reaction chamber 151 is communicated with the first chamber 11, and the microwave generator 152 is connected to the reaction chamber 151 through a wave guide tube 153 for inputting a microwave into the reaction chamber 151. In addition, the magnetic module 154 is connected to the reaction chamber 151 for forming a magnetic field in the reaction chamber 151. In the second framework of the non-contact physical etching system, the working gas inputted into the reaction chamber 151 is transformed to the plasma by the action of the microwave and the magnetic field; moreover, based on a frequency match occurring between the microwave and the magnetic field, an electron cyclotron resonance would be produced in the reaction chamber 151 for largely enhancing the concentration of the plasma.

As shown in FIG. 1A and FIG. 1B, the first mask 21 is disposed in the second chamber 12 and opposite to the target carrying platform 23, and the first mask 21 is connected to the hollow chamber 13 for shielding the outlet opening. In the present invention, the first mask 21 is particularly used as a spontaneous electric field triggering member for the plasma in the hollow chamber 13. In addition, by operating an air pressure maintaining device 16 connected to the first chamber 11 and the second chamber 12, the air in the first chamber 11 and the second chamber 12 can be pumped out so as to keep the atmosphere pressure in the first chamber 11 and the second chamber 12 to a first air pressure and a second air pressure, respectively.

Herein, it needs to stress that, the first technology feature of the non-contact physical etching system is that, the plasma in the hollow chamber 13 would produce a spontaneous electric field near the surface of the first mask 21 for maintaining the electrical neutrality thereof. So that, by the action of the spontaneous electric field perpendicular to the surface of the first mask 21, a plurality of charged ions in the plasma are accelerated and then pass through at least one first pattern formed on the first mask 21, such that the charged ions would etch or cut a target 24 put on the target carrying platform 23 by way of bombarding the target 24.

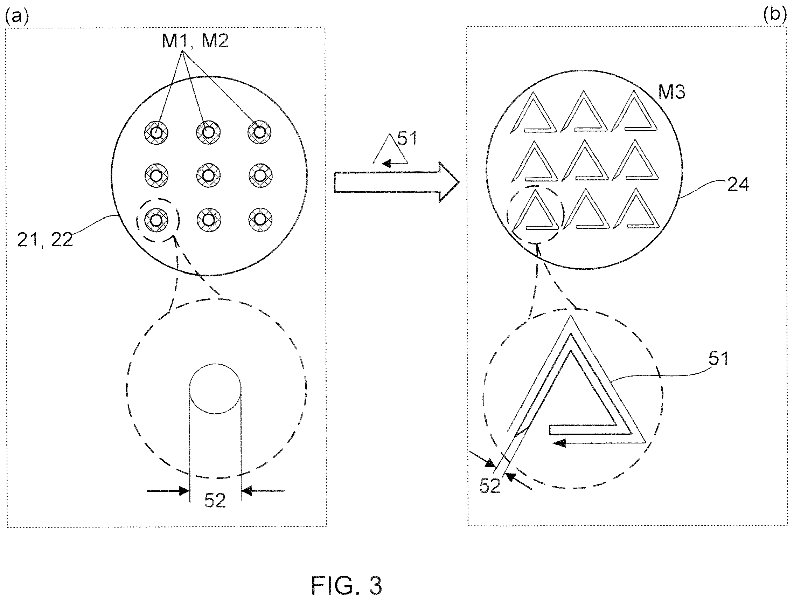

Continuously referring to FIG. 1A and FIG. 1B, and please simultaneously refer to FIG. 3, where the schematic diagrams for a first mask 21 and a second mask 22 are illustrate. In order to avoid the charged ions in the plasma from laterally spread, at least one second mask 22 is disposed in the second chamber 12 and locates between the first mask 21 and the target 24. From FIG. 3, it is able to know that the first pattern M1 formed on the first mask 21 is consisted of at least one aperture 52 or a plurality of aperture s 52; the same to first pattern M1, a second pattern M2 formed on the second mask 22 is consisted of at least one aperture 52 or a plurality of apertures 52. By the disposing of the second mask 22, the charged ions passing through the first pattern M1 are able to further pass through the second pattern M2 on the second mask 22, such that the charged ions are prevented from laterally spread so as to bombard the target 24 straightly and precisely. Another way to reduce the lateral spread of the charged ions is adding one magnetic device into the non-contact physical etching system. As shown in FIG. 1A and FIG. 1B, the added magnetic device 33 is connected to the second chamber 12 for producing a magnetic field in the second chamber 12, such that the charged ions can be avoided from laterally spread based on the action of the a magnetic field.

Moreover, it needs to further explain that, the first pattern M1 (i.e., the aperture 52) formed on the non-metal first mask 21 is enclosed by a metal material in order to facilitate the spontaneous electric field be produced near the surface of the first mask 21. Moreover, in other practicable application, the first mask 21 can also be made of metal materials and subsequently being formed with a non-metal layer thereon. Wherein the said non-metal layer is consisted of at least one third pattern corresponding to the first pattern M1, and the area of the third pattern is designed to be greater than the first pattern M1, so as to make the first pattern M1 be enclosed by the third pattern.

From the diagram (a) depicted by FIG. 3, it is able to know that the basic unit of the first pattern M1 is one aperture 52, and a plurality of apertures 52 constitute a specific pattern of the first pattern M1 on the first mask 21. The same to the first mask 21, the basic unit of the second pattern M2 is one aperture 52, and a plurality of apertures 52 constitute a specific pattern of the second pattern M2 on the second mask 22. As shown in FIG. 3, the said specific pattern of the first pattern M1 and the second pattern M2 can be an aperture array, wherein each of the plurality of the apertures 52 have an identical aperture size.

The second technical feature of the non-contact physical etching system provided by the present invention is that, this non-contact physical etching system can be operated to treat the target 24 put on the target carrying platform 23 with a movable-type etching process by using the first mask 21 and the second mask 22. The said movable-type etching process is illustrated to diagram (b) in FIG. 3. As the diagram (b) of FIG. 3 shows, when the target 24 is treated with an etching process, engineers are able to operate a platform moving device 32 to drive the target carrying platform 23 make motion along a specific moving path 51, such that an etched pattern M3 corresponding to the moving path 51 would be therefore formed on the target 24. As shown in the diagram (b) of FIG. 3, the width of the etched pattern M3 is the same to the aperture size of the aperture 52; that is, as long as the aperture size of the aperture 52 and the moving path 51 are properly set, it is going to carry out any etched patterns with different widths on the target 24 through the movable-type etching process by using this non-contact physical etching system.

Besides, the aforesaid first pattern M1 on the first mask 21 can also be constituted by at least one first string-shaped aperture or a plurality of string-shaped apertures. The same to the first mask 21, the second pattern M2 on the second mask 22 can also consist of at least one second string-shaped aperture or a plurality of second string-shaped apertures. Furthermore, a dot-shaped aperture can be formed by intercrossing any two first string-shaped apertures (or second string-shaped apertures), such that the charged ions in the plasma are able to pass through the first pattern M1 (and second pattern M2) represented by the dot-shaped aperture, so as to bombard the target 24 for completing a etching process or a pattern-making process.

Inheriting to above descriptions, the etching plasma would etch the target 24 according to an intersection pattern between the first pattern M1 and the second pattern M2 when executing the target's 24 etching process via the first mask 21 having the first pattern M1 and the second mask 22 having the second pattern M2. For instance, if the first pattern M1 is identical to the second pattern M2, the said intersection pattern will be the same to the first pattern M1 and the second pattern M2. Moreover, when the first pattern M1 is different from the second pattern M2, a plurality of slit apertures formed by way of oppositely crossing the first pattern M1 and the second pattern M2 are able to be defined as a plurality of intersection points. Furthermore, a plurality of tiny slit apertures can be formed by crisscrossing the first pattern M1 and the second pattern M2. In addition, the first pattern M1 and the second pattern M2 can also be both represented by a slit aperture array with narrow slit width. In which, the intersection pattern between the first pattern M1 and the second pattern M2 will be an aperture array if the directionally-included angles between the slit apertures are designed to be close to 90°. That is, it is going to carry out any etched patterns with different widths on the target 24 through the intersection pattern of the first pattern M1 and the second pattern M2 by using this non-contact physical etching system.

In addition, for making the charged ions in the plasma have enough etching energy, a bias device 31 is added into the non-contact physical etching system. As shown in FIG. 1A and FIG. 1B, the bias device 31 is connected to the first mask 21, the at least one second mask 22 and the target carrying platform 23, and used for forming an electric field between the first mask 21 and the target carrying platform 23, the second mask 22 and the target carrying platform 23, or any two second mask 22. Thus, by the action of the accelerating electric field, the charged ions in the plasma would get enough etching energy so as to etch the target 24 by way of bombarding the target 24. Moreover, when the etching depth is greater than or equal to the target's thickness, the target 24' would be cut or penetrated by the plasma's bombarding ions.

Furthermore, as shown in FIG. 1A and FIG. 1B, an auxiliary device 17 is connected to the main body 1 for measuring a temperature parameter and a plasma parameter. Once the engineers find the working temperature of the main body 1 is too high from the auxiliary device 17, the engineers are going to operate a cooling device 34 connected with the main body 1 for cooling the hollow chamber 13, the target carrying platform 23, and/or the target 24. In addition, when practically applying this non-contact physical system, an alignment device can be used for adjusting a position relationship between the first mask 21, the second mask 22 and the target carrying platform 23, so as to ensure the position relationship be able to meet the requirement of the etching process.

Herein, it needs to further explain that, the mark of ∑1 shown in FIG. 1A and FIG. 1B is indicated to a first working environment, and the said first working environment ∑1 means a plasma producing environment. That is, the first working environment ∑1 consists of the first chamber 11, the hollow chamber 13, the working gas supplying device 14, and the plasma generating device 15. Moreover, above descriptions imply that the first chamber 11, the hollow chamber 13, the working gas supplying device 14, and the plasma generating device 15 can be integrated to one single apparatus for producing and supplying etching plasma. Opposite to the first working environment ∑1, a second working environment ∑2 shown in FIG. 1A and FIG. 1B means a specific environment for executing plasma etching process. That is, the second working environment ∑2 is consisted of the second chamber 12, the first mask 21, the second mask 22, and the target carrying platform 23. Moreover, above descriptions also imply that the second chamber 12, the first mask 21, the second mask 22, and the target carrying platform 23 can be integrated to another one single apparatus for executing the plasma etching process.

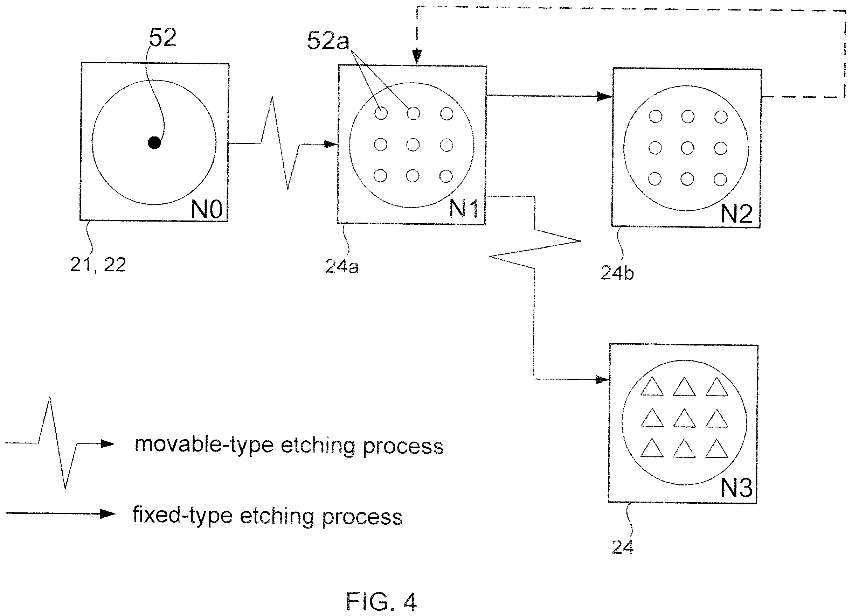

Continuously referring to FIG. 4, there is shown an application diagram of the non-contact physical etching system. From FIG. 4, it is able to know that the non-contact physical etching system can be used to complete a movable-type etching process and/or a fixed-type etching process. Before detailedly introducing the technology feature of the movable-type etching process and the fixed-type etching process, it needs to explain that the first mask 21 (and/or the second mask 22) is provided with a base pattern N0 thereon, wherein the said base pattern N0 can be a single aperture 52. Therefore, a first base mask 24a having a first etched pattern N1 can be fabricated after treating the target 24 with the movable-type etching process by using the first mask 21 (and the second mask 22). As shown in FIG. 4, the said first etched pattern N1 consists of a plurality of apertures 52a.

Furthermore, a copied mask 24b of the first base mask 24a can be manufacture by executing the fixed-type etching process onto the target 24 by using the first base mask 24a. As FIG. 4 shows, the copied mask 24b has a second etched pattern N2 identical to the first etched pattern N1 on the first base mask 24a. In addition, it is able to further form a third etched pattern N3 on the target 24 through the first base mask 24a by using the movable-type etching process. In brief, as long as the aperture size of the aperture 52 and the moving path 51 are properly set, it is going to carry out any etched patterns with given widths on the target 24 through the movable-type etching process by using this non-contact physical etching system. Moreover, the engineers are able to make the copied masks of the first mask 21 and the second mask 22 through the fixe-type etching process, without outsourced manufacturing or purchase.

Therefore, through above descriptions, the non-contact physical etching system has been introduced completely and clearly; in summary, the present invention includes the advantages of:
(1) Differing from conventional wet etching apparatus or dry etching apparatus, the present invention proposes a non-contact physical etching system mainly constituted by a main body 1, a hollow chamber 13, a working gas supplying device 14, a plasma generating device 15, a first mask 21, and a target carrying platform 23. Particularly, this non-contact physical etching system can be used for completing the etching process to the target 24 put on the target carrying platform 23, without treating the target 24 with using any lithography processes in advance.
(2) Moreover, when the non-contact etching process is operated, the plasma in the hollow chamber 13 would produce a spontaneous electric field near the surface of the first mask 21 for maintaining the electrical neutrality thereof; therefore, by the action of the spontaneous electric field perpendicular to the surface of the first mask 21, the charged ions in the plasma would be accelerated and then pass through at least one first pattern M1 formed on the first mask 21, such that the charged ions would etch or cut the target 24 by way of bombarding the target 24. The step of providing the non-contact physical etching system provided by the present invention can also be applied to complete the etch process of biomaterials, medical substrates (for example, blood glucose test strip), and organic materials.
(3) Moreover, in contrast to the currently-used electron beam etching apparatus, FIB etching apparatus and excimer laser etching apparatus have an identical drawback of being unable to be applied to achieve large scale etching process, this non-contact physical etching system is going to treat the target 24 with a large-scale etching process as long as the first mask 21 and the second mask 22 have been properly set.

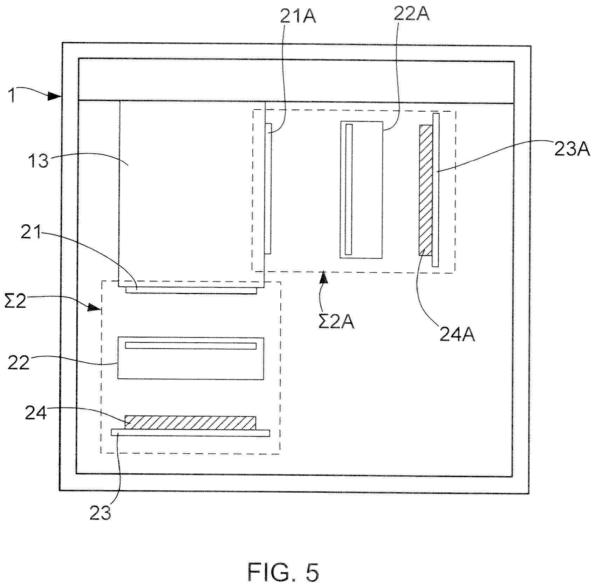

Herein, an expansion-type embodiment for the non-contact physical etching system will be introduced in following paragraphs. Please refer to FIG. 5, where a schematic framework view of the extensional embodiment for the non-contact physical etching system is shown. In the extensional embodiment, hollow chamber 13 disposed in the main body 1 is provided with two outlet openings, and the two outlet openings are shielded by one first mask 21 and one first additional mask 21A. Moreover, the second mask 22 is also disposed between the target carrying platform 23 and the first mask 21. In addition, an additional target carrying platform 23A is disposed in the main body 1 and opposite to the first additional mask 21A, and a second additional mask 22A is disposed between the additional target carrying platform 23A and the second additional mask 22A.

Although the exemplary embodiment for the non-contact physical etching system depicted by FIG. 1A and FIG. 1B merely includes one second working environment ∑2 (i.e., the plasma etching environment), that is not used for limiting the numbers of the plasma etching environments. In other possible applications, it can also disposed two or more plasma etching environments; for example, the expansion-type embodiment for the non-contact physical etching system depicted by FIG. 5 is disposed with two plasma etching environments, i.e., one second working environment ∑2 and one second additionally-working environment ∑2A.

The above description is made on embodiments, including embodiments of the present invention. However, the embodiments are not intended to limit scope of the present invention. The invention is defined by the claims.

## Claims

1. A non-contact physical etching process, comprising the step of:
(1) providing a non-contact physical etching system comprising
a main body (1),
a partition member (10) arranged to isolate a first chamber (11) and a second chamber (12) of the main body (1) from each other,
a hollow chamber (13) having an inlet opening and an outlet opening, the hollow chamber (13) being deposed on the partition chamber (10) such that it simultaneously passes through the first chamber (11) and the second chamber (12), the hollow chamber having a first portion located in the first chamber (11) and a second portion located in the second chamber (12),
a working gas supplying device (14) connected to the main body (1),
a target carrying platform (23) disposed in the second chamber (12),
a first mask (21) disposed in the second chamber (12) opposite the target carrying platform (23), the first mask (21) being connected to the hollow chamber (13) and being arranged to shield the outlet opening of the hollow chamber (13) such that, in use, a plasma in the hollow chamber (13) can be avoided from directly moving into the second chamber (12), wherein the first mask (21) is provided with at least one first pattern formed thereon, the first pattern consisting of at least one first aperture or at least one first string-shaped aperture,
a plasma generating device (15) connected to the working gas supplying device (14) and the main body (1), and
an air pressure maintaining device (16) connected to the first chamber (11) and the second chamber (12);
the non-contact physical etching process further comprising the steps of
(2) using the first chamber (11) and the second chamber (12) as a plasma supplying chamber and a plasma etching chamber, respectively;
(3) carrying a target (24) on the target carrying platform (23);
(4) supplying a working gas into the main body (1) and into the plasma generating device (15);
(5) operating the air pressure maintaining device (16) to pump air out of the first chamber (11) and the second chamber (12) such that the second air pressure in the second chamber (12) is smaller than the first air pressure in the first chamber (11);
(6) transforming the working gas into a plasma and inputting the plasma into the hollow chamber (13) with the plasma generating device (15);
(7) using the first mask (21) as a triggering member such that the plasma in the hollow chamber (13) produces a spontaneous electric field near the surface of the first mask (21), and maintaining thereby the electrical neutrality of the plasma;
(8) producing the spontaneous electric field perpendicular to the surface of the first mask (21), such that a plurality of charged ions in the plasma are accelerated and pass through the at least one first pattern formed on the first mask (21);
(9) bombarding the target (24) with the accelerated charged ions in order to etch or cut the target (24).

2. The non-contact physical etching process of claim 1, wherein the non-contact physical etching system comprises at least one second mask (22) provided with at least one second pattern formed thereon, being disposed in the second chamber (12) and located between the first mask (21) and the target (24).

3. The non-contact physical etching process of claim 1, wherein the non-contact physical etching system comprises a cooling device (34), being connected to the main body (1), and wherein the process comprises the step of using the cooling device (34) for cooling the hollow chamber (13), the target carrying platform (23) and the target (24).

4. The non-contact physical etching process of claim 2, wherein the at least one second pattern consists of at least one second aperture or of at least one second string-shaped aperture.

5. The non-contact physical etching process of claim 1, wherein the non-contact physical etching system comprises a magnetic device (33) connected to the second chamber (12), and wherein the process comprises the step of applying a magnetic field provided by the magnetic device (33) to the second chamber (12) such that the accelerated charged ions can be avoided from laterally spreading.

6. The non-contact physical etching Process of claim 1, wherein the non-contact physical etching system comprises an auxiliary device (17), being connected to the main body (1) for measuring a temperature parameter and a plasma parameter.

7. The non-contact physical etching process of claim 1 or claim 2, wherein the non-contact physical etching system comprises a platform moving device (32), being connected to the target carrying platform (23) for relatively moving the target carrying platform (23) against the first mask (21) or the at least one second mask (22).

8. The non-contact physical etching process of claim 2, wherein the non-contact physical etching system comprises a bias device (31) connected to the first mask (21), the at least one second mask (22) and the target carrying platform (23), and wherein the process comprises the step of using the bias device (31) for forming an electric field between the first mask (21) and the target carrying platform (23) or the at least one second second mask (22) and the target carrying platform (23).

9. The non-contact physical etching process of claim 1, wherein the first pattern of the first mask (21) consists of a dot-shaped aperture formed by intercrossing any two of the first string-shaped apertures.

10. The non-contact physical etching process of claim 4, wherein the at least one second pattern of the second mask (22) consists of a dot-shaped aperture formed by intercrossing any two of the second string-shaped apertures.

## Patentansprüche

1. Kontaktloses physikalisches Ätzverfahren, umfassend den Schritt des:
(1) Bereitstellens eines kontaktlosen physikalischen Ätzsystems, umfassend
einen Hauptkörper (1),
ein Trennelement (10), das dazu angeordnet ist, eine erste Kammer (11) und eine zweite Kammer (12) vom Hauptkörper (1) und voneinander zu isolieren,
eine Hohlkammer (13), die eine Einlassöffnung und eine Auslassöffnung aufweist, wobei die Hohlkammer (13) an der Trennkammer (10) angeordnet ist, sodass sie gleichzeitig die erste Kammer (11) und die zweite Kammer (12) durchdringt, wobei die Hohlkammer einen ersten Teil, der sich in der ersten Kammer (11) befindet und einen zweiten Teil, der sich in der zweiten Kammer (12) befindet, aufweist,
eine Arbeitsgaszufuhrvorrichtung (14), die mit dem Hauptkörper (1) verbunden ist,
eine Zielobjektträgerplattform (23), die in der zweiten Kammer (12) angeordnet ist,
eine erste Abdeckung (21), die in der zweiten Kammer (12) gegenüber der Zielobjekttrageplattform (23) angeordnet ist, wobei die erste Abdeckung (21) mit der Hohlkammer (13) verbunden und derart angeordnet ist, dass sie die Auslassöffnung der Hohlkammer (13) abschirmt, sodass bei der Verwendung ein Plasma in der Hohlkammer (13) davon abgehalten werden kann, direkt in die zweite Kammer (12) einzudringen,
wobei die erste Abdeckung (21) mit mindestens einem darauf gebildeten ersten Muster versehen ist, wobei das erste Muster aus mindestens einer ersten Öffnung oder mindestens einer ersten strangförmigen Öffnung besteht,
eine Plasmaerzeugungsvorrichtung (15), die mit der Arbeitsgaszufuhrvorrichtung (14) und dem Hauptkörper (1) verbunden ist, und
eine Luftdruckhaltevorrichtung (16), die mit der ersten Kammer (11) und der zweiten Kammer (12) verbunden ist;
das kontaktlose physikalische Ätzverfahren umfasst weiterhin die Schritte des:
(2) Verwendens der ersten Kammer (11) und der zweiten Kammer (12) als eine Plasmazufuhrkammer bzw. eine Plasmaätzkammer;
(3) Tragens eines Zielobjekts (24) auf der Zielobjektträgerplattform (23);
(4) Zuführens eines Arbeitsgases in den Hauptkörper (1) und in die Plasmaerzeugungsvorrichtung (15);
(5) Bedienens der Luftdruckhaltevorrichtung (16), um Luft aus der ersten Kammer (11) und der zweiten Kammer (12) abzupumpen, sodass der zweite Luftdruck in der zweiten Kammer (12) kleiner ist als der erste Luftdruck in der ersten Kammer (11) ;
(6) Umwandelns des Arbeitsgases in ein Plasma und Einbringen des Plasmas in die Hohlkammer (13) mit der Plasmaerzeugungsvorrichtung (15);
(7) Verwendens der ersten Abdeckung (21) als ein Auslöseelement, sodass das Plasma in der Hohlkammer (13) ein spontanes elektrisches Feld nahe der Oberfläche der ersten Abdeckung (21) erzeugt und dadurch die elektrische Neutralität des Plasmas erhält;
(8) Erzeugens des spontanen elektrischen Feldes rechtwinklig zu der Oberfläche der ersten Abdeckung (21), sodass mehrere geladene Ionen in dem Plasma beschleunigt werden und durch das mindestens eine erste Muster, das auf der ersten Abdeckung (21) gebildet ist, dringen;
(9) Bombardierens des Zielobjekts (24) mit den beschleunigten geladenen Ionen, um das Zielobjekt (24) zu ätzen oder zu schneiden.

2. Kontaktloses physikalisches Ätzverfahren nach Anspruch 1, wobei das kontaktlose physikalische Ätzsystem mindestens eine zweite Abdeckung (22) umfasst, die mit mindestens einem darauf gebildeten zweiten Muster versehen ist, und die in der zweiten Kammer (12) angeordnet ist und sich zwischen der ersten Abdeckung (21) und dem Zielobjekt (24) befindet.

3. Kontaktloses physikalisches Ätzverfahren nach Anspruch 1, wobei das kontaktlose physikalische Ätzsystem eine Kühlvorrichtung (34) umfasst, die mit dem Hauptkörper (1) verbunden ist, und wobei das Verfahren den Schritt des Verwendens der Kühlvorrichtung (34) zum Kühlen der Hohlkammer (13), der Zielobjektträgerplattform (23) und des Zielobjekts (24) umfasst.

4. Kontaktloses physikalisches Ätzverfahren nach Anspruch 2, wobei das mindestens eine zweite Muster aus mindestens einer zweiten Öffnung oder aus mindestens einer zweiten strangförmigen Öffnung besteht.

5. Kontaktloses physikalisches Ätzverfahren nach Anspruch 1, wobei das kontaktlose physikalische Ätzsystem eine Magnetvorrichtung (33) umfasst, die mit der zweiten Kammer (12) verbunden ist, und wobei das Verfahren den Schritt des Anwendens eines Magnetfelds, das von der Magnetvorrichtung (33) bereitgestellt wird, auf die zweite Kammer (12) umfasst, sodass die beschleunigten geladenen Ionen davon abgehalten werden können, sich seitwärts zu verteilen.

6. Kontaktloses physikalisches Ätzverfahren nach Anspruch 1, wobei das kontaktlose physikalische Ätzsystem eine Hilfsvorrichtung (17) zum Messen eines Temperaturparameters und eines Plasmaparameters umfasst, die mit dem Hauptkörper (1) verbunden ist.

7. Kontaktloses physikalisches Ätzverfahren nach Anspruch 1 oder Anspruch 2, wobei das kontaktlose physikalische Ätzsystem eine Plattformbewegungsvorrichtung (32) umfasst, die mit der Zielobjektträgerplattform (23) verbunden ist, um die Zielobjektträgerplattform (23) relativ gegen die erste Abdeckung (21) oder die mindestens eine zweite Abdeckung (22) zu bewegen.

8. Kontaktloses physikalisches Ätzverfahren nach Anspruch 2, wobei das kontaktlose physikalische Ätzsystem eine Vorspannungsvorrichtung (31) umfasst, die mit der ersten Abdeckung (21), der mindestens einen zweiten Abdeckung (22) und der Zielobjektträgerplattform (23) verbunden ist, und wobei das Verfahren den Schritt des Verwendens der Vorspannungsvorrichtung (31) zum Bilden eines elektrischen Felds zwischen der ersten Abdeckung (21) und der Zielobjektträgerplattform (23) oder der mindestens einen zweiten Abdeckung (22) und der Zielobjektträgerplattform (23) umfasst.

9. Kontaktloses physikalisches Ätzverfahren nach Anspruch 1, wobei das erste Muster auf der ersten Abdeckung (21) aus einer punktförmigen Öffnung besteht, die durch jede zwei der ersten strangförmigen Öffnungen, die einander kreuzen, gebildet wird.

10. Kontaktloses physikalisches Ätzverfahren nach Anspruch 4, wobei das mindestens eine zweite Muster auf der zweiten Abdeckung (22) aus einer punktförmigen Öffnung besteht, die durch jede zwei der zweiten strangförmigen Öffnungen, die einander kreuzen, gebildet wird.

## Revendications

1. Un procédé de gravure physique sans contact, comprenant l'étape consistant à :
(1) prévoir un système de gravure physique sans contact comprenant un corps principal (1),
un élément de séparation (10) agencé pour isoler une première chambre (11) et une deuxième chambre (12) du corps principal (1) l'une de l'autre,
une chambre creuse (13) ayant une ouverture d'entrée et une ouverture de sortie, la chambre creuse (13) étant déposée sur la chambre de séparation (10) de telle sorte qu'elle traverse simultanément la première chambre (11) et la deuxième chambre (12), la chambre creuse ayant une première partie située dans la première chambre (11) et une deuxième partie située dans la deuxième chambre (12),
un dispositif (14) d'alimentation en gaz de travail relié au corps principal (1),
une plate-forme (23) porteuse de cible disposée dans la deuxième chambre (12),
un premier masque (21) disposé dans la deuxième chambre (12) à l'opposé de la plate-forme (23) porteuse de cible, le premier masque (21) étant relié à la chambre creuse (13) et étant agencé pour protéger l'ouverture de sortie de la chambre creuse (13) de telle sorte que, lors de l'utilisation, il est évité qu'un plasma présent dans la chambre creuse (13) se déplace directement dans la deuxième chambre (12), le premier masque (21) étant pourvu d'au moins un premier motif formé sur lui, le premier motif étant constitué d'au moins une première ouverture ou d'au moins une première ouverture en forme de bande,
un dispositif (15) générateur de plasma connecté au dispositif (14) d'alimentation en gaz de travail et au corps principal (1), et
un dispositif (16) de maintien de la pression d'air connecté à la première chambre (11) et à la deuxième chambre (12) ;
le processus de gravure physique sans contact comprenant en outre les étapes consistant à
(2) utiliser la première chambre (11) et de la deuxième chambre (12) en tant qu'une chambre d'alimentation en plasma et en tant qu'une chambre de gravure au plasma, respectivement ;
(3) porter une cible (24) sur la plate-forme (23) porteuse de cible ;
(4) alimenter un gaz de travail dans le corps principal (1) et dans le dispositif (15) générateur de plasma ;
(5) actionner le dispositif (16) de maintien de la pression d'air pour pomper de l'air hors de la première chambre (11) et de la deuxième chambre (12) de telle sorte que la deuxième pression d'air dans la deuxième chambre (12) soit inférieure à la première pression d'air dans la première chambre (11) ;
(6) transformer le gaz de travail en un plasma et introduire le plasma dans la chambre creuse (13) avec le dispositif (15) générateur de plasma ;
(7) utiliser le premier masque (21) comme élément de déclenchement de telle sorte que le plasma dans la chambre creuse (13) produise un champ électrique spontané près de la surface du premier masque (21), et maintenir ainsi la neutralité électrique du plasma ;
(8) produire le champ électrique spontané perpendiculaire à la surface du premier masque (21), de telle sorte que des ions d'une pluralité d'ions chargés dans le plasma soient accélérés et traversent ledit au moins un premier motif formé sur le premier masque (21) ;
(9) bombarder la cible (24) avec les ions chargés accélérés afin de graver ou de découper la cible (24).

2. Le procédé de gravure physique sans contact selon la revendication 1, dans lequel le système de gravure physique sans contact comprend au moins un deuxième masque (22) pourvu d'au moins un deuxième motif formé sur lui, disposé dans la deuxième chambre (12) et situé entre le premier masque (21) et la cible (24).

3. Le procédé de gravure physique sans contact selon la revendication 1, dans lequel le système de gravure physique sans contact comprend un dispositif de refroidissement (34), connecté au corps principal (1), et dans lequel le procédé comprend l'étape consistant à utiliser le dispositif de refroidissement (34) pour refroidir la chambre creuse (13), la plate-forme (23) porteuse de cible et la cible (24).

4. Le procédé de gravure physique sans contact selon la revendication 2, dans lequel ledit au moins un deuxième motif est constitué d'au moins une deuxième ouverture ou d'au moins une deuxième ouverture en forme de bande.

5. Le procédé de gravure physique sans contact selon la revendication 1, dans lequel le système de gravure physique sans contact comprend un dispositif magnétique (33) connecté à la deuxième chambre (12), et dans lequel le procédé comprend l'étape consistant à appliquer un champ magnétique fourni par le dispositif magnétique (33) à la deuxième chambre (12) de sorte qu'il est évité que les ions chargés accélérés se diffusent latéralement.

6. Le procédé de gravure physique sans contact selon la revendication 1, dans lequel le système de gravure physique sans contact comprend un dispositif auxiliaire (17), connecté au corps principal (1) pour mesurer un paramètre de température et un paramètre de plasma.

7. Le procédé de gravure physique sans contact selon la revendication 1 ou la revendication 2, dans lequel le système de gravure physique sans contact comprend un dispositif (32) de déplacement de plate-forme, connecté à la plate-forme (23) porteuse de cible pour déplacer relativement la plate-forme (23) porteuse de cible contre le premier masque (21) ou ledit au moins un deuxième masque (22).

8. Le procédé de gravure physique sans contact selon la revendication 2, dans lequel le système de gravure physique sans contact comprend un dispositif de polarisation (31) connecté au premier masque (21), audit au moins un deuxième masque (22) et à la plate-forme (23) porteuse de cible, et dans lequel le procédé comprend l'étape consistant à utiliser le dispositif de polarisation (31) pour former un champ électrique entre le premier masque (21) et la plate-forme (23) porteuse de cible ou ledit au moins un deuxième masque (22) et la plate-forme (23) porteuse de cible.

9. Le procédé de gravure physique sans contact selon la revendication 1, dans lequel le premier motif du premier masque (21) consiste en une ouverture en forme de point formée en entrecroisant deux quelconques des premières ouvertures en forme de bande.

10. Le procédé de gravure physique sans contact selon la revendication 4, dans lequel ledit au moins un deuxième motif du deuxième masque (22) consiste en une ouverture en forme de point formée en entrecroisant deux quelconques des deuxièmes ouvertures en forme de bande.
